(19)

Europäisches
Patentamt

European
Patent Office

Office européen
des brevets

(11) **EP 2 131 396 A1**

(12) **DEMANDE DE BREVET EUROPEEN**

(43) Date de publication:
**09.12.2009 Bulletin 2009/50**

(51) Int Cl.:
***H01L 27/11*** (2006.01)    ***H01L 21/8244*** (2006.01)

(21) Numéro de dépôt: **09160432.2**

(22) Date de dépôt: **15.05.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **02.06.2008 FR 0853608**

(71) Demandeur: **Commissariat à l'Energie Atomique Bâtiment D "Le Ponant"**
**25 rue Leblanc**
**75015 Paris (FR)**

(72) Inventeurs:
• **Thomas, Olivier**
**38420, REVEL (FR)**

• **Batude, Perrine**
**38000, GRENOBLE (FR)**
• **Pouydebasque, Arnaud**
**38420, LE VERSOUD (FR)**
• **Vinet, Maud**
**38140, RIVES (FR)**

(74) Mandataire: **Ilgart, Jean-Christophe et al**
**Brevalex**
**3, rue du Docteur Lancereaux**
**75008 Paris (FR)**

(54) **Cellule de mémoire SRAM à transistors intégrés sur plusieurs niveaux et dont la tension de seuil vt est ajustable dynamiquement**

(57)    L'invention concerne une cellule de mémoire vive non-volatile à accès aléatoire, comprenant sur un substrat surmonté d'un empilement de couches,
- une première pluralité de transistors situés à un niveau donné de l'empilement dont au moins un premier transistor d'accès ($MA_L$) et au moins un deuxième transistor d'accès ($MA_R$) disposés respectivement entre une première ligne de bit ($BL_L$) et un premier noeud de stockage (L), et entre une deuxième ligne de bit ($BL_R$) et un deuxième noeud de stockage (R)
- une deuxième pluralité de transistors ($ML_L$, $ML_R$, $MD_L$, $MD_R$) formant une bascule et situés à au moins un autre niveau de l'empilement inférieur audit niveau donné.

FIG.3A

**Description**

**DOMAINE TECHNIQUE**

L'invention se rapporte au domaine des mémoires, et notamment à celui des mémoires statiques à accès aléatoires SRAM (RAM pour « random access memory »). L'invention concerne en particulier une structure de cellule mémoire améliorée, dotée de transistors superposés dont une pluralité de transistors ont une tension de seuil modulable par couplage avec la grille de transistors de niveau inférieur.

Elle apporte des avantages notamment en termes d'encombrement, et la possibilité de modifier de manière dynamique la tension de seuil de certains des transistors afin d'améliorer leurs caractéristiques électriques telles que la stabilité, la consommation.

**ÉMAT DE LA TECHNIQUE ANTÉRIEURE**

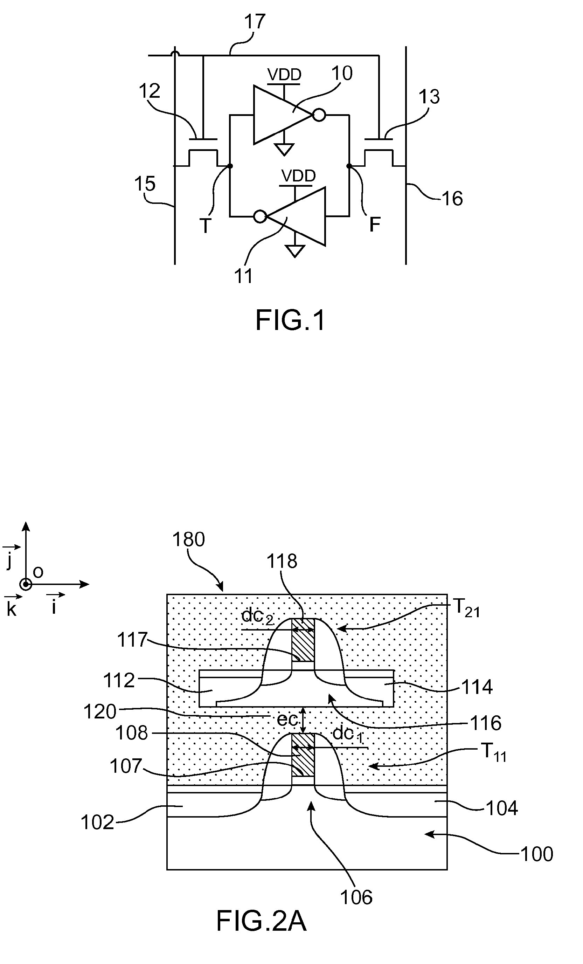

Une cellule mémoire SRAM classique (SRAM pour « static random access memory » ou mémoire vive statique) comprend généralement deux inverseurs 10, 11, connectés selon une configuration dite « de bascule » ou « flip-flop » et de deux transistors d'accès 12, 13 connectés à des lignes de bit 15 et 16, et commandés par une ligne de mot 17 (figure 1).

Les caractéristiques recherchées pour une cellule mémoire sont :

- une bonne stabilité en lecture également appelée SNM (SNM pour « Static Noise Margin »),
- une marge en écriture également appelée WM (WM pour « Write Margin ») suffisante,
- une bonne stabilité en rétention RNM (RNM pour « Retention Noise Margin »),
- un courant de conduction Icell le plus important possible pour donner à la cellule une vitesse de fonctionnement élevée,
- une taille de cellule la plus faible possible pour permettre de réaliser une mémoire avec une densité d'intégration de cellules importante,
- un courant en rétention Ioff le plus faible possible afin de minimiser la puissance consommée statique.

Ces critères ne pouvant être conciliés, les concepteurs de mémoires sont amenés à faire des compromis entre eux.

Des cellules mémoires SRAM dites « 4T », à quatre transistors, ont été développées. Les cellules 4T ont un encombrement réduit et permettent d'obtenir une forte densité d'intégration. Les cellules 4T ont pour inconvénient d'avoir un manque de stabilité en mode de rétention. Ce manque de stabilité peut être pallié par un système de rafraîchissement. Typiquement, le dimensionnement des cellules 4T, est réalisé en tenant compte du meilleur compromis qui peut être atteint entre la stabilité en phase de rétention et la stabilité en phase de lecture.

En cherchant à réduire de plus en plus les tailles des transistors des cellules mémoires, les paramètres de ces transistors tels que leur largeur W de canal, leur longueur L de canal, leur tension de seuil $V_T$, leur perméabilité $\mu_0$, leur dopage Na, leur épaisseur d'oxyde de grille Tox, fluctuent. Cela entraîne une augmentation de la sensibilité des cellules mémoires face aux différentes sources de bruit. Le développement d'une cellule mémoire présentant une marge au bruit élevée devient donc de plus en plus une priorité.

Les cellules SRAM à six transistors appelées cellules « 6T », offrent quant à elles un bon compromis entre tous les critères précités.

Pour les cellules mémoire 6T conventionnelles, la stabilité des cellules est déterminée par leur marge au bruit statique en mode lecture (SNM). En effet, lors d'un accès en lecture, le gain des inverseurs de la cellule a tendance à être diminué par la mise en conduction des transistors d'accès.

Des cellules mémoires à 8 ou à 9 transistors (8T ou 9T) ont également été réalisées. Malgré une forte amélioration de la marge au bruit statique SNM, ces cellules ont un encombrement important par rapport aux cellules 6T.

Par ailleurs, des cellules SRAM réalisées en technologie SOI partiellement désertée ou totalement désertée, dans lesquelles le rapport entre marge au bruit statique et marge en lecture sont améliorées, ont été développées. Des cellules SRAM réalisées en technologie double grille ou finFET, dans lesquelles la marge au bruit statique a été améliorée, ont également été mises en oeuvre. Ces cellules ne permettent pas de réaliser une bonne densité d'intégration.

Il de pose le problème de trouver une nouvelle structure de cellule mémoire SRAM présentant d'une part une bonne stabilité en rétention, en lecture et en écriture, tout en conservant un encombrement amélioré.

**EXPOSÉ DE L'INVENTION**

La présente invention concerne une cellule de mémoire vive statique à accès aléatoire, comprenant sur un substrat surmonté d'un empilement de couches :

- une première pluralité de transistors situés à un niveau donné de l'empilement dont au moins un premier transistor d'accès et au moins un deuxième transistor d'accès connectés à une ligne de mot et disposés respectivement entre une première ligne de bit et un premier noeud de stockage, et entre une deuxième ligne de bit et un deuxième noeud de stockage,
- une deuxième pluralité de transistors formant une bascule et situés à au moins un autre niveau de l'empilement en dessous dudit niveau donné,
  les transistors de la deuxième pluralité de transistors comportant chacun une électrode de grille située en regard d'une zone de canal d'un transistor de la deuxième pluralité de transistors et séparée de cette zone de canal par l'intermédiaire d'une zone isolante prévue pour permettre un couplage entre ladite électrode de grille et ladite zone de canal.

Une telle cellule présente à la fois une densité d'intégration et des performances électriques améliorées par rapport à une cellule mémoire SRAM classique suivant l'art antérieur.

Selon une possibilité, la deuxième pluralité de transistors peut être formée : d'un premier transistor de conduction et d'un deuxième transistor de conduction, le premier transistor de conduction ayant une grille située en regard de la zone de canal du premier transistor d'accès, le deuxième transistor de conduction ayant une grille située en regard de la zone de canal du deuxième transistor d'accès.

Selon une deuxième possibilité la deuxième pluralité de transistor peut être formée : d'un premier transistor de charge et d'un deuxième transistor de charge, le premier transistor de charge ayant une grille située en regard de la zone de canal du premier transistor d'accès, le deuxième transistor de charge ayant une grille située en regard de, la zone de canal du deuxième transistor d'accès.

Selon une troisième possibilité, la deuxième pluralité de transistor peut être formée : d'un premier transistor de charge et d'un deuxième transistor de charge, d'un premier transistor de conduction, et d'un deuxième transistor de conduction.

Le premier transistor de charge et le deuxième transistor de charge peuvent être respectivement, disposés en regard, au deuxième transistor de conduction et au premier transistor de conduction.

Le premier transistor de charge et le deuxième transistor de charge, le premier transistor de conduction, et le deuxième transistor de conduction peuvent être formés dans un même niveau dudit empilement.

Selon une autre possibilité, la première pluralité de transistors peut comprendre en outre : au moins un troisième transistor d'accès et au moins un quatrième transistor d'accès, disposés respectivement entre une troisième ligne de bit et le premier noeud de stockage, et entre une quatrième ligne de bit et un deuxième noeud de stockage, le troisième transistor d'accès et le quatrième transistor d'accès ayant une grille connectés à une deuxième ligne de mot.

La zone isolante peut avoir une épaisseur $e_c$ équivalente en $SiO_2$ comprise entre 1 et 50 nanomètres, par exemple entre 10 et 50 nanomètres.

Par épaisseur $e_c$ équivalente en $SiO_2$, on entend que si la zone diélectrique est à base d'un matériau diélectrique différent du $SiO_2$, comprise entre 1 et 50 nanomètres, par exemple entre 10 et 50 nanomètres.

Le couplage peut être tel qu'une variation du potentiel de ladite électrode de grille entraine une variation de la tension de seuil de ladite zone de canal.

Le couplage peut être tel qu'une variation du potentiel de ladite électrode de grille d'au plus de Vdd, permette d'obtenir une variation de la tension de seuil de ladite zone de canal d'au moins 50 mV.

Entre ladite grille et ladite zone de canal, ladite zone isolante peut être formée d'une première région à base d'un premier matériau diélectrique ayant une première constante diélectrique $k_1$, en regard des zones de source et de drain, ladite zone isolante étant formée d'une deuxième région comportant au moins un deuxième matériau diélectrique ayant une deuxième constante diélectrique $k_2$ telle que $k_2 < k_1$.

La deuxième région peut comporter un empilement dudit premier matériau diélectrique et dudit deuxième matériau diélectrique.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un exemple de cellule SRAM suivant l'art antérieur,
- les figures 2A-2C illustrent des exemples d'agencements de transistors dans une cellule mémoire SRAM suivant l'invention,
- les figures 3A-3C, illustrent un premier exemple de cellule mémoire SRAM 4T suivant l'invention,

- la figure 4 donne une courbe d'évolution de la tension de seuil de transistors dans le premier exemple de cellule mémoire SRAM 4T suivant l'invention,
- les figures 5A-5C illustrent un autre exemple de cellule SRAM 4T suivant l'invention,
- les figures 6A-6C illustrent un exemple de cellule SRAM suivant l'invention, à 6 transistors répartis sur 3 niveaux,
- les figures 7A-7C illustrent un autre exemple de cellule SRAM suivant l'invention, à 6 transistors répartis sur 3 niveaux,
- les figures 8A-8C illustrent un autre exemple de cellule SRAM suivant l'invention, à 6 transistors répartis sur 2 niveaux,
- les figures 9A-9C illustrent un autre exemple de cellule SRAM suivant l'invention à 6 transistors répartis sur 2 niveaux,
- les figures 10A-10B illustrent un autre exemple de cellule SRAM suivant l'invention à 6 transistors répartis sur 2 niveaux.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

Un agencement de transistors, tel que prévu dans une cellule mémoire mise en oeuvre suivant l'invention, va à présent être donné en liaison avec la figure 2A.

Les transistors sont réalisés sur un substrat 100, qui peut être un substrat massif (« bulk » suivant la terminologie anglo-saxonne) ou de type semi-conducteur sur isolant, par exemple de type SOI (SOI pour « silicon on insulator » ou « silicium sur isolant »), comportant une première couche de support qui peut être semi-conductrice et par exemple à base de Si, recouverte par une couche isolante, par exemple à base de $SiO_2$, elle-même recouverte par une couche semi-conductrice, par exemple à base de Si, et dans laquelle une ou plusieurs zones actives sont susceptibles d'être formée(s).

Sur le substrat 100, repose un empilement de couches dans lequel figure un premier transistor $T_{11}$ comportant une région de source 102, une région de drain 104, ainsi qu'une zone 106 de canal, reliant la région de source 102 et la région de drain 104. Le premier transistor $T_{11}$ peut être éventuellement formé sur un substrat SOI totalement déserté ou partiellement déserté.

Le transistor $T_{11}$ comporte également une grille 108 située sur une couche de matériau diélectrique 107 de grille 108.

Le matériau diélectrique 107 peut avoir une épaisseur équivalente en $SiO_2$, également appelée épaisseur EOT (EOT pour « Equivalent Oxide Thickness ») comprise entre 1 et 50 nm. Le matériau diélectrique 107 peut être par exemple du $SiO_2$ ou un matériau de type communément appelé « high-k » tel que du $HfO_2$.

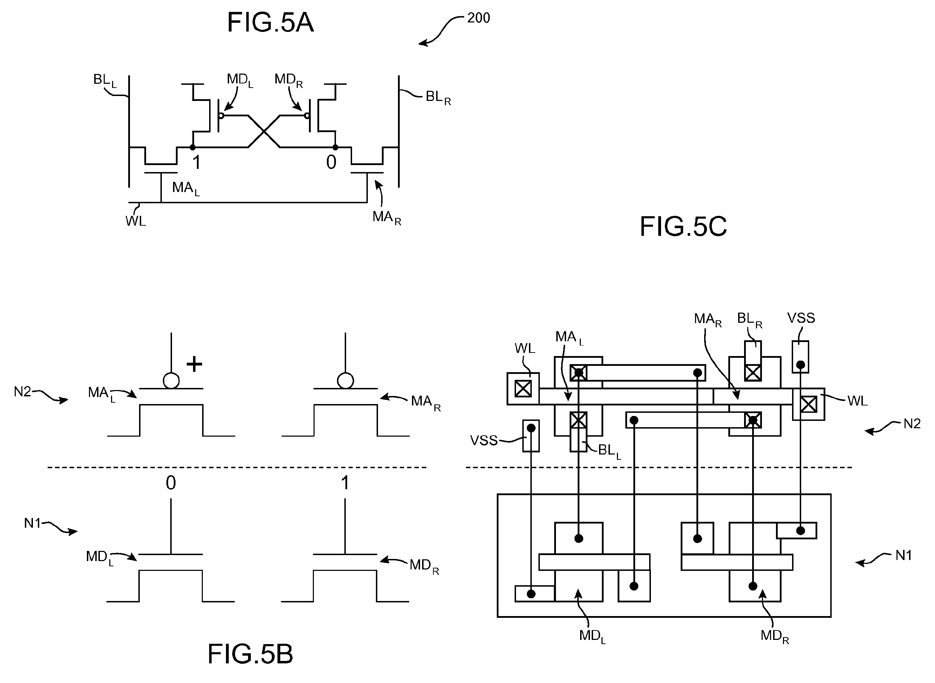

La grille 108 du premier transistor $T_{11}$, peut avoir une dimension critique $dc_1$ comprise par exemple entre 10 et 100 nanomètres (la dimension critique $dc_1$ étant mesurée dans une direction parallèle à celle du vecteur $\vec{i}$ d'un repère orthogonal $[0; \vec{i}; \vec{j}; \vec{k}]$ donné sur la figure 5). Tout au long de la présente description, on entend par « dimension critique », la plus petite dimension d'un motif hormis son épaisseur.

La grille du premier transistor $T_{11}$ peut également avoir une épaisseur comprise par exemple entre 10 et 100 nanomètres (l'épaisseur de la grille étant mesurée dans une direction parallèle à celle du vecteur $\vec{j}$ d'un repère orthogonal $[0; \vec{i}; \vec{j}; \vec{k}]$ donné sur la figure 5).

La grille 108 du premier transistor $T_{11}$ peut être par exemple à base d'un matériau semi-conducteur dopé tel que du polysilicium ou d'un métal par exemple tel que du TiN.

Le dispositif comporte également au moins un deuxième transistor $T_{21}$ formé au dessus du premier transistor $T_{11}$, dans un niveau de l'empilement supérieur à celui du niveau dans lequel se trouve le premier transistor $T_{11}$.

Le deuxième transistor $T_{21}$ comporte une région de source 112, une région de drain 114, ainsi qu'une structure de canal 116, reliant la région de source 112 et la région de drain 114. Le deuxième transistor $T_{21}$ comporte également une grille 118 reposant sur une couche de diélectrique 117 de grille.

Le diélectrique 117 de grille peut avoir une épaisseur comprise par exemple entre 0.5 et 4 nanomètres. Le diélectrique de grille peut être par exemple du SiO2 ou un matériau de type communément appelé « high-k » tel que du HfO2.

La grille 118 du deuxième transistor T21 peut avoir une dimension critique $dc_2$ comprise par exemple entre 10 et 100 nanomètres ($dc_2$ étant mesurée dans une direction parallèle à celle du vecteur $\vec{i}$ du repère orthogonal $[0; \vec{i}; \vec{j}; \vec{k}]$). La grille du deuxième transistor $T_{21}$ peut également avoir une épaisseur comprise entre 10 nanomètres et 100 nanomètres. La grille du deuxième transistor $T_{21}$ peut être par exemple à base d'un matériau semi-conducteur tel que du polysilicium ou d'un métal par exemple tel que du TiN.

La grille 108 du premier transistor $T_{11}$ et la zone de canal du deuxième transistor $T_{21}$ sont espacés d'une distance ou d'une épaisseur $e_c$, choisie ou prédéterminée. La grille 108 du premier transistor $T_{11}$ et la zone de canal

du deuxième transistor $T_{21}$ sont séparés par une zone isolante 120 formée d'une couche ILD (ILD pour « Inter layer dielectric » selon la terminologie anglo-saxonne ou diélectrique inter-niveaux) de faible épaisseur.

La zone isolante peut être par exemple à base de $SiO_2$ ou d'un matériau diélectrique communément appelé « high-k » tel que du $HfO_2$.

La zone isolante 120 est mise en oeuvre de manière à permettre un couplage entre la grille 108 du premier transistor $T_{11}$ et le canal du deuxième transistor $T_{21}$, situé au dessus et en regard de la grille 108 du premier transistor $T_{11}$.

De préférence, l'épaisseur de cette zone isolante $e_c$ est en particulier choisie bien inférieure à celle des épaisseurs des couches de matériaux diélectrique inter-niveaux dans les dispositifs suivant l'art antérieur, et qui dans ces dispositifs, est prévue pour permettre d'isoler entre eux différents niveaux superposés de composants ou de lignes d'interconnexions.

Par épaisseur $e_c$ ou distance $e_c$ « faible », on entend que $e_c$ peut être comprise entre 1 et 50 nanomètres d'épaisseur équivalente en $SiO_2$, pour permettre le couplage.

En plus de l'épaisseur, la nature du matériau diélectrique de la zone isolante, par exemple du $SiO_2$ ou du $HfO_2$, est également choisie pour permettre d'obtenir un couplage entre la grille du transistor de niveau inférieur et la zone de canal du transistor de niveau.

L'épaisseur équivalente EOT en $SiO_2$, d'un diélectrique « high-k » d'épaisseur $T_{high-k}$ est obtenue par la relation suivante :

$$EOT = \frac{\varepsilon_{SiO2}}{\varepsilon_{high-k}} \cdot T_{high-k}$$

Avec un tel dispositif, en fonction de la manière dont la polarisation de la grille 108 du premier transistor $T_{11}$ est prévue, la tension de seuil $V_T$ du canal du deuxième transistor $T_{21}$ peut être ajustée. A l'aide d'un tel dispositif, pour faire varier la tension de seuil $V_T$ du canal du deuxième transistor $T_{21}$, on peut faire varier le potentiel appliqué sur la grille 108 du transistor $T_{11}$ de niveau inférieur.

La grille du premier transistor $T_{11}$ permet ainsi de commander le potentiel de canal du transistor $T_{21}$ de niveau supérieur.

Le premier transistor $T_{11}$ et le deuxième transistor $T_{21}$ sont disposés de sorte que la grille 108 du premier transistor $T_{11}$ est située en regard de la zone semi-conductrice 116 de canal du deuxième transistor $T_{21}$. Dans cet exemple, les grilles 108 et 118 ont des motifs alignés dans une direction orthogonale au plan principal du substrat (dans une direction parallèle à celle du vecteur $\vec{j}$ du repère orthogonal $[0; \vec{i}; \vec{j}; \vec{k}]$).

De préférence, pour obtenir un meilleur contrôle du potentiel de canal du deuxième transistor $T_{21}$, l'intégralité de la face supérieure ou du dessus de la grille 108 du premier transistor $T_{11}$ est disposée en regard de la zone semi-conductrice 116 de canal du deuxième transistor $T_{21}$.

La zone de canal 116 du deuxième transistor $T_{21}$ peut être réalisée dans une couche semi-conductrice de faible épaisseur, de manière à permettre un contrôle statique au niveau du canal d'inversion. Par faible épaisseur, on entend que la zone de canal 116 du deuxième transistor $T_{21}$ peut être formée dans une couche semi-conductrice d'épaisseur comprise par exemple entre 1 et 100 nm, ou par exemple entre 5 et 20 nanomètres. L'épaisseur choisie pour la couche semi-conductrice dans laquelle est réalisée le canal 116 est prévue notamment en fonction du niveau de dopage de cette couche pour permettre un comportement totalement déplété.

Les zones de canal des transistors $T_{11}$ et $T_{21}$ peuvent être formées par exemple dans du Si ou dans un autre matériau semi-conducteur, par exemple tel que du Ge.

La zone isolante séparant la grille du transistor $T_{11}$ à la couche semi-conductrice sur laquelle le transistor $T_{21}$ est réalisé, est prévue pour permettre un couplage significatif de la grille avec le substrat. Par couplage significatif, on entend un couplage permettant de faire varier la tension de seuil du transistor $T_{21}$ de niveau supérieur d'au moins 50 mV, pour une variation de la tension appliquée à la grille du transistor $T_{11}$ de niveau inférieur entre 0 et Vdd ou -Vdd et +Vdd selon l'application, avec Vdd la tension d'alimentation du dispositif. La tension Vdd peut être par exemple de l'ordre de 1 Volt ou de 0.5 V

Un modèle tel que celui décrit dans l'article de Lim et Fossum : IEEE Transactions on electron devices, vol. ED-30, n˚10 Octobre 1983, peut être utilisé pour dimensionner la zone isolante 120 afin d'obtenir une variation de tension de seuil désirée ΔVth lorsque l'on fait varier de ΔV le potentiel de polarisation de la grille 108 du premier transistor $T_{11}$.

Un tel modèle peut être utilisé en particulier dans le cas où le deuxième transistor $T_{21}$ est réalisé sur une couche totalement désertée.

$$\Delta V_{th} = \frac{\dfrac{\varepsilon_{sc}}{T_{sc}} \cdot \dfrac{\varepsilon_{ILD}}{T_{ILD}}}{\dfrac{\varepsilon_{ox}}{T_{ox}} \cdot \left( \dfrac{\varepsilon_{sc}}{T_{sc}} + \dfrac{\varepsilon_{ILD}}{T_{ILD}} \right)} \cdot \Delta V$$

Avec :

- $\Delta$Vth la variation de tension de seuil du deuxième transistor $T_{21}$,
- $\varepsilon_{sc}$, $T_{sc}$, respectivement la permittivité diélectrique et l'épaisseur de la couche semi-conductrice dans laquelle le canal 116 du transistor $T_{21}$ est réalisé,
- $\varepsilon_{ox}$, $T_{ox}$, respectivement la permittivité diélectrique et l'épaisseur du diélectrique de grille du deuxième transistor $T_{21}$,
- $\varepsilon_{ILD}$, $T_{ILD}$, respectivement la permittivité diélectrique et l'épaisseur du diélectrique de la zone isolante 120 séparant la couche semi-conductrice du deuxième transistor $T_{21}$ de la grille 108 du premier transistor $T_{11}$.

Cela donne, lorsque le potentiel de la grille du premier transistor inférieur $T_{11}$ varie de 0 à Vdd :

$$\Delta V_{th} = \frac{\dfrac{\varepsilon_{sc}}{T_{sc}} \cdot \dfrac{\varepsilon_{ILD}}{T_{ILD}}}{\dfrac{\varepsilon_{ox}}{T_{ox}} \cdot \left( \dfrac{\varepsilon_{sc}}{T_{sc}} + \dfrac{\varepsilon_{ILD}}{T_{ILD}} \right)} \cdot V_{DD} \qquad (1)$$

Pour atteindre un couplage significatif correspondant à une variation de tension de seuil $\Delta$Vth = 50mV, dans le cas où les grilles 108 et 118 ont une dimension critique de l'ordre de 45 nm, que l'épaisseur $T_{sc}$ de la zone de canal 116 est égale à 7 nm, que cette dernière est en silicium, que l'épaisseur $T_{ox}$ de la zone de diélectrique 117 est égale à 1 nm, que cette dernière est à base de $SiO_2$, que Vdd = 1V, et que la zone 120 est en $SiO_2$, la zone isolante 120 est prévue par exemple avec une épaisseur de l'ordre 17,5 nm.

Pour atteindre par exemple un couplage identique avec une zone isolante séparant les transistors superposés à base de $HfO_2$ avec une permittivité de 20, l'épaisseur physique de la couche de « high-k » est de l'ordre 90,5 nm.

Dans le cas où le diélectrique de la zone isolante 120 est à base d'un matériau « high-k », l'épaisseur $T_{high-k}$ à prévoir pour cette zone isolante 120 est déterminée par la formule précédente, en remplaçant Tox par :

$$Tox = \frac{\varepsilon_{SiO2}}{\varepsilon_{high-k}} \cdot T_{high-k}$$

Le premier transistor $T_{11}$ et le deuxième transistor $T_{21}$, peuvent être également dotés de zones d'accès au canal siliciurées.

Le premier transistor $T_{11}$ et le deuxième transistor $T_{21}$ sont des transistors d'une cellule mémoire, en particulier d'une cellule mémoire SRAM.

Une modification dynamique de la tension de seuil $V_T$ du deuxième transistor peut être obtenue à l'aide de moyens (non représentés) pour appliquer un potentiel variable, prévus pour :

- lors d'une phase, appliquer un premier potentiel sur la grille du premier transistor,
- lors d'une autre phase, appliquer un autre potentiel sur la grille du premier transistor.

Un exemple de dispositif microélectronique avec deux transistors, vient d'être décrit. Mais un dispositif suivant l'invention peut comprendre un nombre plus élevés de transistors, par exemple un nombre n (avec n un entier tel que n > 2) de transistors $T_{11}$, $T_{21}$, $T_{(n-1)1}$, $T_{n1}$ superposés, chaque transistor $T_k$ d'un niveau donné $N_k$ (avec k un entier tel que 1 < k < n) comportant une zone de canal susceptible d'être couplée à l'électrode de grille d'un transistor $T_{k-1}$ de niveau $N_{k-1}$ inférieur au niveau donné $N_k$, cette grille étant située en regard de ladite zone de canal, à une distance suffisamment faible pour permettre un tel couplage.

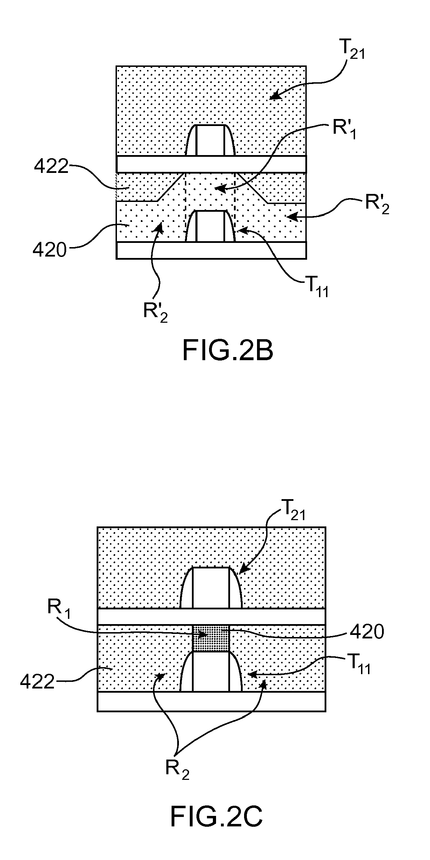

Un autre exemple de dispositif microélectronique, mis en oeuvre suivant l'invention, est illustré sur la figure 2B.

Ce dispositif diffère de celui décrit précédemment en liaison avec la figure 2B, en ce qu'il comporte entre les transistors $T_{11}$ et $T_{21}$, une zone isolante comportant plusieurs matériaux diélectriques différents, en particulier ayant des constantes diélectriques différentes, l'épaisseur et la répartition desdits matériaux diélectriques étant prévues de manière à permettre un couplage dans une première région $R_1$ située entre la grille du premier transistor $T_{11}$ et le canal du deuxième transistor $T_{21}$, et empêcher le couplage entre les transistors $T_{11}$ et $T_{21}$ dans une région R2 située autour de cette première région R1.

Pour cela, la grille 108 du premier transistor $T_{11}$ et la zone de canal 116 du deuxième transistor $T_{21}$ sont séparés par un premier matériau diélectrique 420 ayant une première constante diélectrique $k_1$.

Autour de cette première région R1, au dessus des régions de source et de drain du premier transistor $T_{11}$ sont prévus des zones isolantes formées à base d'un deuxième matériau diélectrique 422 ayant une deuxième constante diélectrique $k_2$, telle que $k_2 < k_1$.

La première région R1 peut être remplie d'un matériau diélectrique « high-k » par exemple tel que du $HfO_2$, tandis que la région située autour de cette première région peut être remplie d'un matériau diélectrique de constante diélectrique plus faible tel que du $SiO_2$.

Avec un tel dispositif, en fonction de la manière dont la polarisation de la grille 108 du premier transistor $T_{11}$ est prévue, la tension de seuil $V_T$ du canal du deuxième transistor $T_{21}$ peut être ajustée. La grille du premier transistor $T_{11}$ permet ainsi de commander le potentiel de canal du transistor $T_{21}$ de niveau supérieur. On évite cependant les phénomènes de couplage du deuxième transistor $T_{21}$ avec le premier transistor $T_{11}$ dans des zones situées en dehors du canal du deuxième transistor.

Un autre exemple de dispositif microélectronique, mis en oeuvre suivant l'invention, est illustré sur la figure 2C. Comme dans l'exemple décrit précédemment en liaison avec la *figure 14*, ce dispositif comporte une zone isolante séparant les transistors $T_{11}$ et $T_{21}$, avec plusieurs matériaux diélectriques différents.

La grille 108 du premier transistor $T_{11}$ et la zone de canal 116 du deuxième transistor $T_{21}$ sont séparés par une première région R'1 à base d'un premier matériau diélectrique 420, par exemple un matériau diélectrique ayant une première constante diélectrique $k_1$. Autour de cette première région R'1, dans une région R'2 située au dessus des régions de source et de drain du premier transistor $T_{11}$ figure des zones isolantes formées d'un empilement du premier matériau diélectrique 420 et d'un deuxième matériau diélectrique 422 ayant une deuxième constante diélectrique $k_2$, telle que $k_2 < k_1$.

Le premier transistor $T_{11}$ et le deuxième transistor $T_{21}$ sont des transistors d'une cellule mémoire, en particulier d'une cellule mémoire SRAM, par exemple une cellule SRAM à quatre transistors (4T) ou une cellule SRAM à 6 transistors (6T).

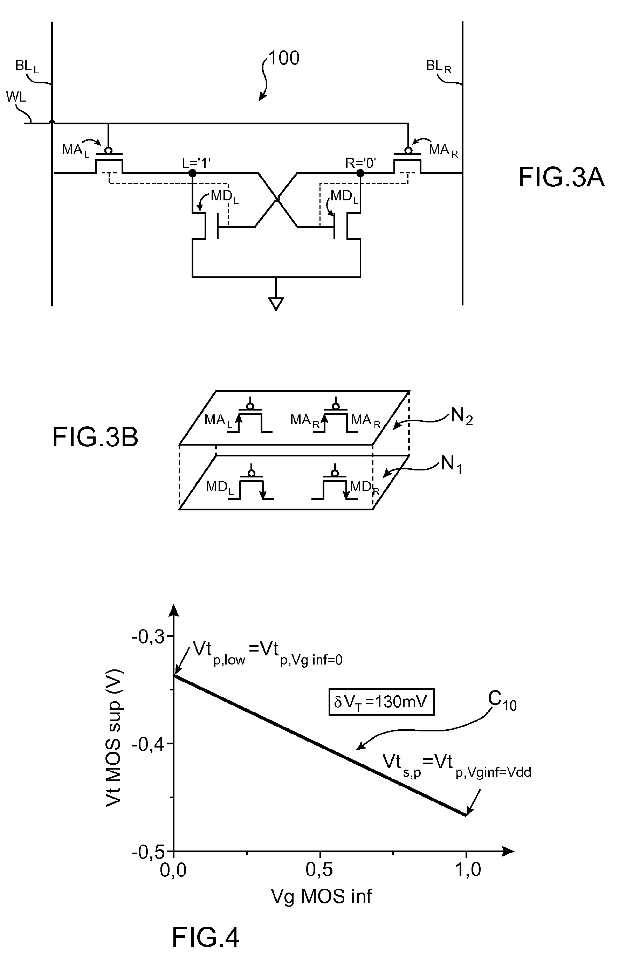

Un premier exemple de cellule mémoire 100 à accès aléatoire suivant l'invention, est illustré sur les figures 3A-3C.

Cette cellule mémoire 100 est une cellule de mémoire statique SRAM de type 4T, c'est à dire dotée de 4 transistors. La cellule 100 comprend une pluralité de transistors formant un premier inverseur et un deuxième inverseur, connectés selon une configuration de bascule ou communément appelée « flip-flop ».

Dans cet exemple, la bascule est formée à l'aide d'un premier transistor de conduction $MD_L$ et d'un deuxième transistor de conduction $MD_R$, par exemple de type NMOS. La grille du deuxième transistor de conduction $MD_R$ est connectée à un premier noeud de stockage L de la cellule 100, tandis que la grille du premier transistor de conduction $MD_L$ est connectée à un deuxième noeud de stockage R de la cellule 100. Les sources des transistors de conduction $MD_L$, $MD_R$, sont quant à elles reliées entre elles et à un potentiel de masse Vss, tandis que le drain du premier transistor de conduction $MD_L$ est relié au premier noeud L et que le drain du deuxième transistor de conduction $MD_R$ est relié au deuxième noeud R. Les transistors de conduction $MD_L$, $MD_R$ sont prévus pour maintenir une charge nécessaire à l'établissement d'un niveau logique donné par exemple '0', correspondant par exemple à un potentiel égal au potentiel Vss, sur l'un des noeuds L ou R, en fonction de la valeur logique mémorisée dans la cellule 100.

La cellule 100 est également dotée d'un premier transistor d'accès $MA_L$ et d'un deuxième transistor d'accès $MA_R$. Les transistors d'accès $MA_L$ et $MA_R$, comportent une grille reliée à une ligne de mot WL. La source du premier transistor d'accès $MA_L$ est reliée à une première ligne de bit $BL_L$, tandis que la source du deuxième transistor d'accès $MA_R$ est reliée à une deuxième ligne de bit $BL_R$. Le drain du premier transistor d'accès $MA_L$ est quant à lui relié au premier noeud de stockage L, tandis que le drain du deuxième transistor d'accès $MA_R$ est relié au deuxième noeud de stockage R. Les transistors d'accès $MA_L$, $MA_R$, sont agencés pour permettre d'accéder aux noeuds de stockage L et R, lors d'une phase de lecture ou d'écriture de la cellule 100, et à bloquer l'accès de la cellule 100, lorsque la cellule 100 est dans un mode de rétention d'information.

Dans une telle cellule, les transistors $MD_L$ et $MA_L$, ont un agencement semblable respectivement à celui du

premier transistor $T_{11}$ et du deuxième transistor $T_{21}$ de l'exemple de dispositif décrit précédemment en liaison avec les figures 2A-2C. Les transistors $MD_L$, $MA_L$, sont en effet superposés et disposés de sorte que la zone de canal du premier transistor d'accès $MA_L$ est située au dessus et en regard de la grille du premier transistor de conduction $MD_L$ à une distance prévue pour permettre un couplage entre la grille du transistor $MD_L$ de conduction et le canal du transistor d'accès $MA_L$ (un tel couplage étant schématisé sur la figure 3A par un trait discontinu entre le transistor de conduction $MD_L$ et le transistor d'accès $MA_L$). Le transistor d'accès $MA_L$ et le premier transistor de conduction $MD_L$ sont séparés par une zone isolante d'épaisseur et de composition prévues pour permettre un tel couplage.

Du fait d'un tel agencement, la tension de seuil du premier transistor d'accès $MA_L$ dépend de la polarisation de la grille du premier transistor de conduction $MD_L$.

Dans une telle cellule, les transistors $MD_R$ et $MA_R$, ont également un agencement semblable respectivement à celui du premier transistor $T_{11}$ et du deuxième transistor $T_{21}$ de l'exemple de dispositif décrit précédemment en liaison avec les figures 2A-2C.

Les transistors $MD_R$, $MA_R$, sont également superposés, et agencés de sorte que la zone de canal du deuxième transistor d'accès $MA_R$ est située au dessus et en regard de la grille du deuxième transistor de conduction à une distance prévue pour permettre un couplage entre la grille du deuxième transistor de conduction $MD_R$ et le canal du deuxième transistor d'accès $MA_R$.

Le transistor d'accès $MA_R$ et le transistor de conduction $MD_R$ sont séparés par une zone isolante d'épaisseur et de composition prévues pour permettre un couplage.

Du fait d'un tel agencement, la tension de seuil du deuxième transistor d'accès $MA_R$ dépend de la polarisation de la grille du deuxième transistor de conduction $MD_L$.

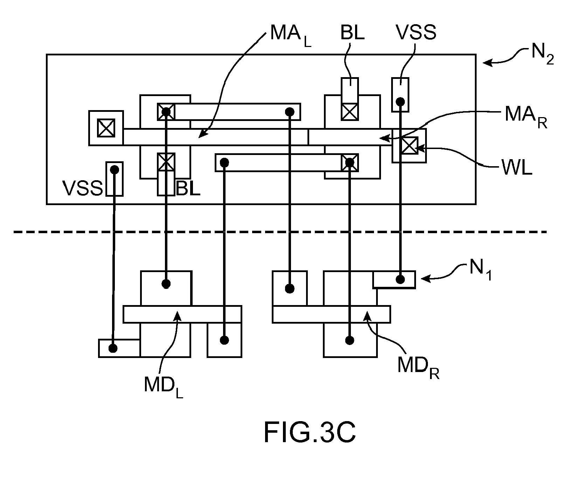

Les transistors $MD_L$, $MD_R$, $MA_L$, $MA_R$ sont formés dans un empilement de couches minces, les transistors de conduction $MD_L$ et $MD_R$ étant situés dans un même premier niveau N1 de l'empilement, tandis que les transistors d'accès $MA_L$ et $MA_R$ sont situés au dessus des transistors de conduction $MD_L$ et $MD_R$, dans un même deuxième niveau N2 de l'empilement (figures 3B et 3C).

Les transistors d'accès $MA_L$, $MA_R$ ont ainsi une tension de seuil modulable en fonction du potentiel respectif de grilles des transistors de conduction $MD_L$, $MD_R$.

Si l'on dispose un transistor d'accès de type PMOS au dessus d'un transistor de conduction de type NMOS de la manière décrite précédemment, la tension de seuil du transistor d'accès peut varier d'une valeur de référence notée Vt s,p lorsque la grille du transistor de conduction est polarisée à un potentiel d'alimentation Vdd par exemple égal à 1 V, à une valeur basse notée Vtp,low lorsque la grille du transistor de conduction inférieur est polarisée à 0 V (courbe $C_{10}$ de la figure 4A).

Un mode de fonctionnement de la cellule 100 est le suivant :

En mode de rétention, les lignes de bit $BL_L$, $BL_R$, sont mises à un potentiel Vdd tandis que la ligne de mot WL est également maintenue au potentiel d'alimentation Vdd pour stabiliser la donnée mémorisée. Les transistors d'accès $MA_L$ et $MA_R$ se trouvent alors dans un état bloqué. Dans le cas où le premier noeud L est à un niveau logique haut, par exemple au potentiel Vdd, et que le deuxième noeud R est à un niveau logique bas, par exemple à 0 V, le premier transistor de conduction $MD_L$ est également bloqué, tandis que le deuxième transistor de conduction $MD_R$ est conducteur. Pour garder le potentiel du premier noeud L proche de Vdd, un courant $I_{MAL\text{-}OFF}$ qui traverse le premier transistor d'accès $MA_L$ est prévu supérieur au courant $I_{MDL\text{-}OFF}$ qui traverse le premier transistor de conduction $MD_R$ associé au courant de grille issu de $ML_L$ ($I_{MLL\text{-}G}$) :

$$I_{MAL\text{-}OFF} \; > \; I_{MDL\text{-}OFF} + I_{MDR\text{-}G}$$

En raison de la configuration de la cellule 100, dans cet exemple le premier transistor d'accès $MA_L$ a une tension de seuil $V_T$ basse susceptible d'augmenter le courant $I_{MAL\text{-}OFF}$ ce qui permet de garantir une bonne marge au bruit en rétention (RNM).

En mode de lecture, la ligne de mot WL est polarisée à VSS pour accéder à la donnée mémorisée dans les noeuds de stockage L, R via les lignes de bit $BL_L$ et $BL_R$. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le premier transistor de conduction $MD_L$ est également bloqué, tandis que le deuxième transistor de conduction $MD_R$ est conducteur. Pour garder le potentiel du deuxième noeud R proche de 0, un courant $I_{MAR\text{-}ON}$ qui traverse le deuxième transistor d'accès $MA_R$ est prévu inférieur au courant $I_{MDR\text{-}ON}$ qui traverse le deuxième transistor de conduction $MD_R$ :

$$I_{MAR-ON} < I_{MDR-ON}$$

En raison de la configuration de la cellule 100, dans cet exemple le deuxième transistor d'accès $MA_R$ a une tension de seuil de référence proche de la tension de seuil du transistor MDR, ce qui permet d'obtenir une bonne marge au bruit en lecture (SNM).

La cellule 100 peut avoir une SNM de l'ordre de 150 mV et une RNM de l'ordre de 320 mV.

En augmentant la largeur des transistors de conduction le compromis entre SNM et RNM peut être amélioré (diminution de la RNM et augmentation de la SNM).

La cellule 100 apporte également une amélioration en termes de compromis entre stabilité en lecture et stabilité en rétention par rapport à une cellule 4T suivant l'art antérieur.

Une telle configuration de cellule peut également permettre de se passer de dispositif de rafraîchissement.

En plaçant les transistors d'accès au dessus des transistors de conduction, on augmente également la densité d'intégration, par rapport à une cellule mémoire 4T suivant l'art antérieur. Une réduction de surface occupée de l'ordre 16,4 % par rapport à une cellule selon l'art antérieur peut être obtenue.

Un deuxième exemple de cellule mémoire 200 à accès aléatoire suivant l'invention, est illustré sur les figures 5A-5C.

Cette cellule mémoire 200 est une variante de la cellule mémoire 4T décrite précédemment. La cellule 200 comprend une pluralité de transistors formant un premier inverseur et un deuxième inverseur, connectés selon une configuration de bascule.

Dans cet exemple, la bascule est formée à l'aide d'un premier transistor de charge $ML_L$ et d'un deuxième transistor de charge $ML_R$, par exemple de type PMOS. Les sources des transistors de charge $ML_L$, $ML_R$, sont reliées à un potentiel d'alimentation Vdd, tandis que le drain du premier transistor de charge $ML_L$ est relié au premier noeud L et que le drain du deuxième transistor de charge $ML_R$ est relié au deuxième noeud R.

La cellule 200 est également dotée d'un premier transistor d'accès $MA_L$ et d'un deuxième transistor d'accès $MA_R$, par exemple de type NMOS. Les transistors d'accès $MA_L$, $MA_R$, sont agencés pour permettre d'accéder aux noeuds de stockage L et R, lors d'une phase de lecture ou d'écriture de la cellule 200, et de bloquer l'accès de la cellule 200, lorsque la cellule 200 est dans un mode de rétention d'information.

Dans une telle cellule 200, les transistors $ML_L$ et $MA_L$, ont un agencement semblable respectivement à celui du premier transistor $T_{11}$ et du deuxième transistor $T_{21}$ de l'exemple de dispositif décrit précédemment en liaison avec les figures 2B-2C. Les transistors $ML_L$, $MA_L$, sont superposés et disposés de sorte que la zone de canal du premier transistor d'accès $MA_L$ est située au dessus et en regard de la grille du premier transistor de charge $ML_L$, à une distance prévue pour permettre un couplage entre la grille du transistor $ML_L$ de charge et le canal du transistor d'accès $MA_L$.

Du fait d'un tel agencement, la tension de seuil du premier transistor d'accès $MA_L$ est dépendante de la tension de polarisation de la grille du premier transistor de charge $ML_L$.

Dans une telle cellule, les transistors $ML_R$ et $MA_R$, ont également un agencement semblable respectivement à celui du premier transistor $T_{11}$ et du deuxième transistor $T_{21}$ de l'exemple de dispositif décrit précédemment en liaison avec les figures 2B-2C.

La zone de canal du deuxième transistor d'accès $MA_R$ est couplée avec la grille du deuxième transistor de charge $ML_L$.

La tension de seuil du deuxième transistor d'accès $MA_R$ dépend ainsi de la manière dont la grille du deuxième transistor de charge $ML_R$ est polarisée.

Comme cela est illustré sur les figures 5B et 5C, dans la cellule mémoire 200, les transistors $ML_L$, $ML_R$, $MA_L$, $MA_R$, sont formés dans un empilement de couches, et agencés de sorte que les transistors de charge $ML_L$ et $ML_R$ sont situés dans un même premier niveau $N_1$ de l'empilement, tandis que les transistors d'accès $MA_L$ et $MA_R$ sont situés au dessus des transistors de conduction, dans un même deuxième niveau $N_2$ de l'empilement.

Un mode de fonctionnement de la cellule 200 est le suivant :

En mode de rétention, les lignes de bit $BL_L$, $BL_R$, sont mises à un potentiel 0 tandis que la ligne de mot WL est également maintenue au potentiel de masse VSS afin de stabiliser la donnée mémorisée. Les transistors d'accès $MA_L$ et $MA_R$ se trouvent alors dans un état bloqué. Dans le cas où le premier noeud L est à un niveau logique haut, par exemple au potentiel Vdd, et que le deuxième noeud R est à un niveau logique bas, par exemple à 0 V, le deuxième transistor de charge $ML_R$ est également bloqué, tandis que le premier transistor de charge $ML_L$ est conducteur. Pour garder le potentiel du deuxième noeud R proche de 0V, un courant $I_{MAR-OFF}$ qui traverse le deuxième transistor d'accès $MA_R$ est prévu supérieur au courant $I_{MLR-OFF}$ qui traverse le deuxième transistor de charge $ML_R$ associé au courant de grille issu de $ML_L$ ($I_{MLL-G}$) :

$$I_{MAR-OFF} > I_{MLR-OFF} + I_{MLL-G}$$

En raison de la configuration de la cellule 200, dans cet exemple le deuxième transistor d'accès $MA_R$ a une tension de seuil VT basse augmentant $I_{MAR-OFF}$ et garantissant de manière intrinsèque une bonne marge au bruit en rétention (RNM).

En mode de lecture, la ligne de mot WL est polarisée à un potentiel VDD pour accéder à la donnée mémorisée dans les noeuds de stockage L, R via les lignes de bit $BL_L$ et $BL_R$. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le premier transistor de charge $ML_L$ est également conducteur, tandis que le deuxième transistor de charge $ML_R$ est bloqué. Pour garder le potentiel du deuxième noeud L proche de VDD, un courant $I_{MAL-ON}$ qui traverse le premier transistor d'accès $MA_L$ est prévu inférieur au courant $I_{MLL-ON}$ qui traverse le premier transistor de charge $ML_L$ :

$$I_{MAL-ON} < I_{MLL-ON}$$

En raison de la configuration de la cellule 200, dans cet exemple $MA_L$ à une tension de seuil de référence proche de la tension de seuil du transistor deuxième transistor de conduction $MD_R$, ce qui permet d'obtenir une bonne marge au bruit en lecture (SNM).

Une telle cellule 200 présente également une marge en lecture améliorée, ainsi qu'un meilleur compromis entre marge en lecture et en rétention qu'une cellule 4T classique.

En plaçant les transistors d'accès au dessus des transistors de conduction, on augmente également la densité d'intégration, par rapport à une cellule mémoire 4T suivant l'art antérieur.

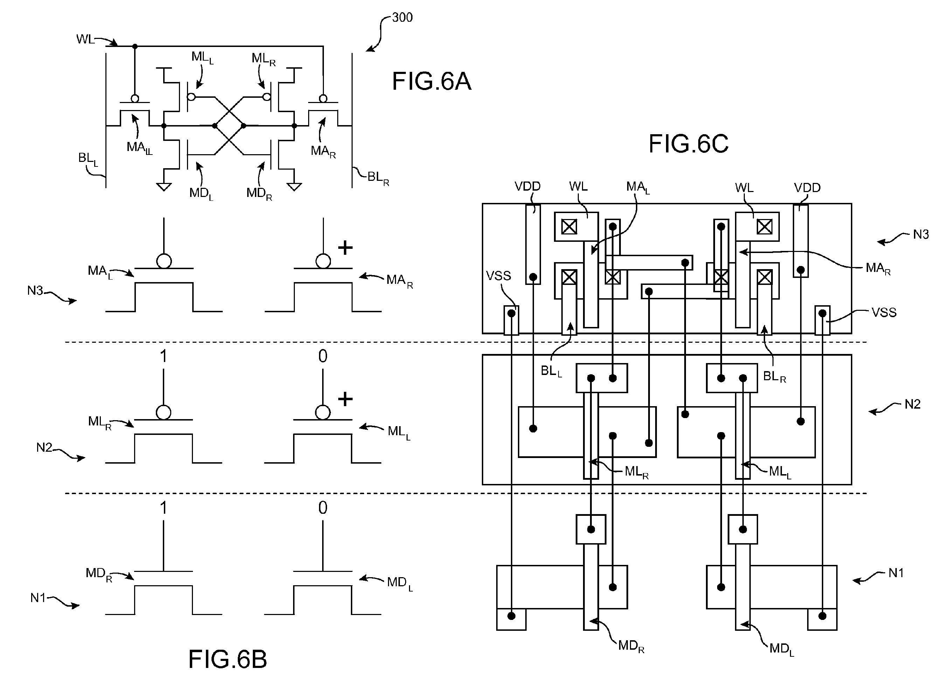

Un troisième exemple de cellule mémoire 300 à accès aléatoire suivant l'invention, est illustré sur les figures 6A-6C.

Cette cellule mémoire 300 est une cellule de mémoire statique SRAM de type 6T, c'est à dire dotée de 6 transistors.

La cellule 300 comprend une pluralité de transistors formant un premier inverseur et un deuxième inverseur, connectés selon une configuration de bascule. Dans cet exemple, la bascule est formée à l'aide d'un premier transistor de conduction $MD_L$ et d'un deuxième transistor de conduction $MD_R$, par exemple de type NMOS, ainsi que d'un premier transistor de charge $ML_L$ et d'un deuxième transistor de charge $ML_R$, par exemple de type PMOS.

La grille du deuxième transistor de conduction $MD_R$ est connectée au premier noeud de stockage L de la cellule 300, tandis que la grille du premier transistor de conduction $MD_L$ est connectée au deuxième noeud de stockage R de la cellule 300.

Les sources des transistors de conduction $MD_L$, $MD_R$, sont quant à elles reliées chacune à un potentiel de masse Vss, tandis que le drain du premier transistor de conduction $MD_L$ est relié au premier noeud L et que le drain du deuxième transistor de conduction $MD_R$ est relié au deuxième noeud R.

Les sources des transistors de charge $ML_L$, $ML_R$, sont reliées chacune à un potentiel d'alimentation Vdd, tandis que le drain du premier transistor de charge $ML_L$ est relié au premier noeud L et que le drain du deuxième transistor de charge $ML_R$ est relié au deuxième noeud R.

La cellule 300 est également dotée d'un premier transistor d'accès $MA_L$ et d'un deuxième transistor d'accès $MA_R$.

Dans une telle cellule, les transistors $MD_R$ et $ML_R$ sont superposés et ont un agencement semblable respectivement à celui du premier transistor $T_{11}$ et du deuxième transistor $T_{21}$ de l'exemple de dispositif décrit précédemment en liaison avec les figures 2B-2C.

Ainsi, les transistors $MD_R$, $ML_R$, sont disposés de sorte que la zone de canal du deuxième transistor de charge $ML_R$ est située au dessus et en regard de la grille du deuxième transistor de conduction $MD_R$, et séparés par une épaisseur isolante prévue pour permettre un couplage entre cette grille et ce canal.

Les transistors $ML_L$ et $MD_L$ ont également un agencement semblable respectivement à celui du premier transistor $T_{11}$ et du deuxième transistor $T_{21}$ de l'exemple de dispositif décrit précédemment en liaison avec les figures 2B-2C.

Du fait d'un tel agencement, la tension de seuil du premier transistor de charge $ML_L$ dépend de la polarisation de la grille du premier transistor de conduction $MD_L$.

Les transistors $ML_R$ et $MA_L$ ont également un agencement semblable respectivement à celui du premier transistor $T_{11}$ et du deuxième transistor $T_{21}$ de l'exemple de dispositif décrit précédemment en liaison avec les figures 2B-2C.

Les transistors $ML_R$, $MA_L$, sont disposés de sorte que la zone de canal du premier transistor d'accès $MA_L$ est située au dessus et en regard de, et est couplée à, la grille du deuxième transistor de charge $ML_R$.

Les transistors $ML_L$ et $MA_R$ ont également un agencement semblable respectivement à celui du premier transistor $T_{11}$ et du deuxième transistor $T_{21}$ de l'exemple de dispositif décrit précédemment en liaison avec les figures 2B-2C.

Du fait d'un tel agencement, la tension de seuil du deuxième transistor d'accès $MA_R$ dépend de la tension de polarisation de la grille du premier transistor de charge $ML_L$.

Comme cela est illustré sur les figures 6B et 6C, dans la cellule mémoire 300, les transistors $MD_L$, $MD_R$, $MA_L$, $MA_R$, $ML_L$, $ML_R$ sont formés dans un empilement de couches minces et répartis sur 3 niveaux N1, N2, N3 différents de l'empilement, les transistors de conduction $MD_L$ et $MD_R$ étant situés dans un même premier niveau N1 de l'empilement, tandis que les transistors de charge $ML_L$ et $ML_R$ sont situés au dessus des transistors de conduction, dans un même deuxième niveau N2 de l'empilement, les transistors d'accès $MA_L$, $MA_R$, étant situés au dessus des transistors de charge $ML_L$ et $ML_R$ dans un même troisième niveau N3 de l'empilement.

Un mode de fonctionnement de la cellule 300 est le suivant :

En mode de lecture, les lignes de bit $BL_L$, $BL_R$, sont mises au potentiel de masse VSS, tandis que la ligne de mot WL est également maintenue à ce potentiel VSS pour accéder à la donnée mémorisée dans les noeuds de stockages L, R via les lignes de bit BLL et BLR. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Pour garder le potentiel du premier noeud L proche de vdd, un courant $I_{MAL-ON}$ qui traverse le premier transistor d'accès $MA_L$ est prévu inférieur au courant $I_{MLL-ON}$ qui traverse le premier transistor de charge $ML_L$ :

$$I_{MAL-ON} < I_{MLL-ON}$$

En raison de la configuration de la cellule 300, dans cet exemple, le premier transistor de charge $ML_L$ a une tension de seuil basse, ce qui permet d'augmenter le courant $I_{MLL-ON}$ et d'augmenter la marge au bruit en lecture (SNM). En mode écriture, la ligne de mot WL est polarisée à VSS pour accéder à la donnée mémorisée dans les noeuds de stockage L, R via les lignes de bit BLL et BLR. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Dans le cas où on veut écrire un 0, la première ligne de bit $BL_L$ est maintenue à 0V et la deuxième ligne de bit $BL_R$ est polarisée à Vdd. Pour charger le deuxième noeud de stockage R à Vdd, un courant $I_{MAR-ON}$ qui traverse le deuxième transistor d'accès $MA_R$ est prévu supérieur au courant $I_{MDR-ON}$ qui traverse le deuxième transistor de conduction $MD_R$ :

$$I_{MAR-ON} > I_{MDR-ON}$$

En raison de la configuration de la cellule 300, dans cet exemple le deuxième transistor d'accès $MA_R$ à une tension de seuil VT basse ce qui permet d'augmenter $I_{MAR-ON}$ et d'augmentant la marge en écriture (WM).

En plus de présenter une meilleure densité d'intégration, une telle cellule 300 présente un meilleur compromis entre marge en écriture WM et stabilité en lecture SNM qu'une mémoire 6T suivant l'art antérieur.

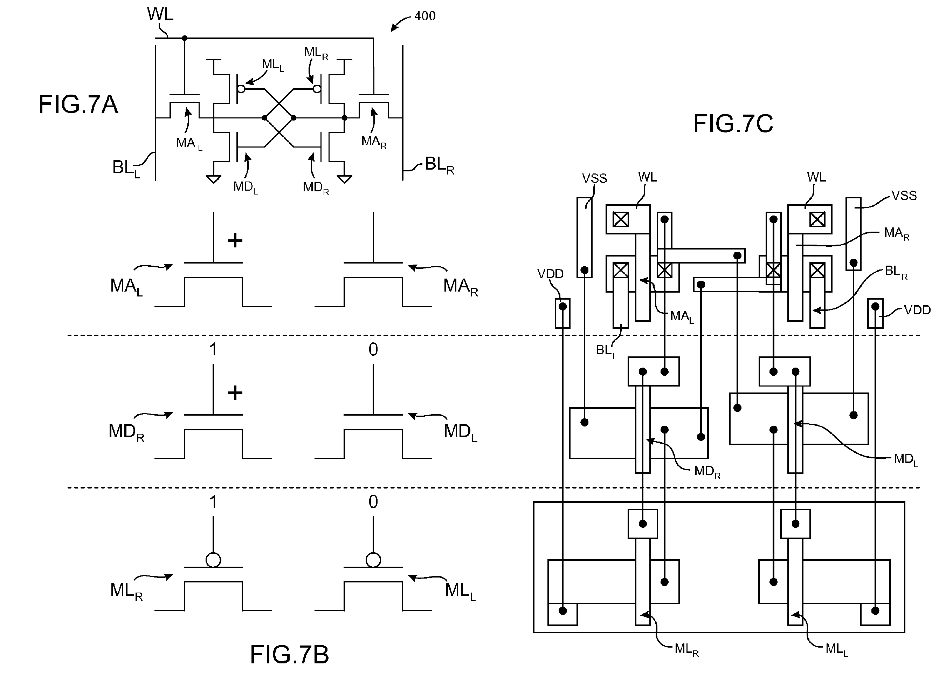

Un quatrième exemple de cellule mémoire 400 à accès aléatoire suivant l'invention, est illustré sur les figures 7A-7C.

La cellule mémoire 400 est également une cellule de mémoire statique SRAM de type 6T. Dans cet exemple, les transistors d'accès $MA_L$, $MA_R$, sont des transistors de type NMOS.

La cellule 400 diffère de la cellule décrite précédemment de par l'agencement des transistors de conduction $MD_L$ et $MD_R$ et des transistors de charge $ML_L$ et $ML_R$.

Dans la cellule mémoire 400, les transistors de charge $ML_L$, $ML_R$ sont formés dans premier niveau N1 d'un empilement de couches, tandis que les transistors $MD_L$, $MD_R$, sont formés dans deuxième niveau N2 de l'empilement situé au dessus du premier niveau N1, les transistors d'accès $MA_L$, $MA_R$, étant quant à eux formés dans un troisième niveau N3 situé au dessus du deuxième niveau N2.

L'agencement des transistors d'accès $MA_L$, $MA_R$ par rapport aux transistors de charge $ML_L$, $ML_R$ est tel que la tension de seuil du premier transistor d'accès $MA_L$, dépend de la polarisation de la grille du deuxième transistor de conduction $MD_R$, tandis que la tension de seuil du deuxième transistor d'accès $MA_R$, dépend de la polarisation de la grille du premier transistor de conduction $MD_L$.

L'agencement des transistors de conduction $MD_L$, $MD_R$ par rapport aux transistors de charge $ML_L$, $ML_R$, est tel que la tension de seuil du premier transistor de conduction $MD_L$, dépend de la polarisation de la grille du premier transistor de charge $ML_L$, tandis que la tension de seuil du deuxième transistor de conduction $MD_R$, dépend de la polarisation de la grille du deuxième transistor de charge $ML_R$.

Un mode de fonctionnement de la cellule 400 est le suivant :

En mode de lecture, les lignes de bit $BL_L$, $BL_R$, sont mises à un potentiel VDD tandis que la ligne de mot WL est également maintenue à VDD pour accéder à la donnée mémorisée dans les noeuds de stockages L, R via les lignes de bit BLL et BLR. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Pour garder le potentiel du deuxième noeud R proche de 0V, un courant $I_{MAR-ON}$ qui traverse le deuxième transistor d'accès $MA_R$ est prévu inférieur au courant $I_{MDR-ON}$ qui traverse le deuxième transistor de conduction $MD_R$ :

$$I_{MAR-ON} < I_{MDR-ON}$$

De par la configuration la cellule 400, dans cet exemple, le deuxième transistor de conduction $MD_R$ à une tension de seuil basse ce qui permet d'augmenter $I_{MDR-ON}$ et d'augmenter la marge au bruit en lecture (SNM).

En mode écriture, la ligne de mot WL est polarisée à VDD pour accéder à la donnée mémorisée dans les noeuds de stockage L, R via les lignes de bit BLL et BLR. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Dans le cas où on veut écrire un 0, la première ligne de bit $BL_L$ est polarisée à 0V et la deuxième ligne de bit $BL_R$ est maintenue à VDD. Pour décharger le premier noeud de stockage L à 0V, un courant $I_{MAL-ON}$ qui traverse le premier transistor d'accès $MA_L$ est prévu supérieur au courant $I_{MLL-ON}$ qui traverse le premier transistor de conduction $ML_L$ :

$$I_{MAL-ON} > I_{MLL-ON}$$

De par la configuration de la cellule 400, dans cet exemple $MA_L$ à une tension de seuil VT basse ce qui permet d'augmentant $I_{MAL-ON}$ et d'augmenter la marge en écriture (WM).

Une telle cellule 400 présente un meilleur compromis entre marge en écriture WM et stabilité en lecture SNM qu'une cellule mémoire 6T suivant l'art antérieur, ainsi qu'une meilleure densité d'intégration.

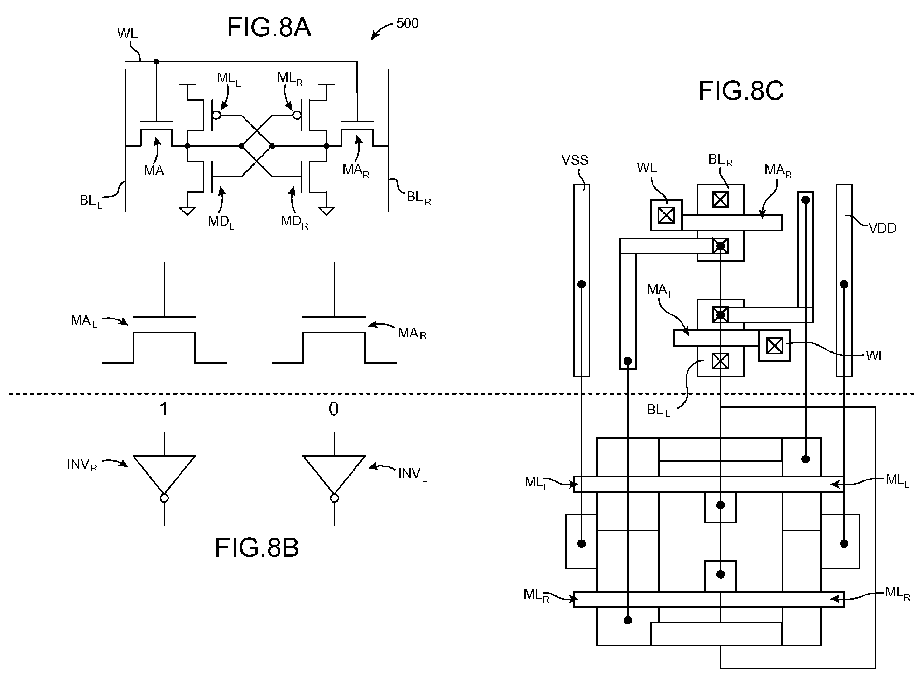

Un cinquième exemple de cellule mémoire 500 à accès aléatoire suivant l'invention, est illustré sur les figures 8A-8C.

Cette cellule mémoire 500 est également une cellule de mémoire statique SRAM de type 6T.

La cellule 500 comprend une pluralité de transistors $MD_L$, $MD_R$, $ML_L$, $ML_R$ formant un premier inverseur $INV_L$ et une pluralité de transistors $MD_L$, $MD_R$, $ML_L$, $ML_R$ formant un deuxième inverseur $INV_R$.

La cellule 500 diffère de la cellule décrite précédemment de par l'agencement des transistors de conduction $MD_L$ et $MD_R$ et de charge $ML_L$ et $ML_R$ qui sont cette fois réalisés au même niveau d'un empilement de couches minces, les transistors d'accès $MA_L$ et $MA_R$ étant quant à eux réalisés à un niveau supérieur (figures 8B et 8C).

Un mode de fonctionnement de la cellule 500 est le suivant :

En mode écriture, la ligne de mot WL est polarisée à VDD pour accéder à la donnée mémorisée dans les noeuds de stockage L, R via les lignes de bit BLL et BLR. Les transistors d'accès $MA_L$ et $MA_R$ se trouvent alors dans un état conducteur. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Dans le cas par exemple où on veut écrire un 0, la première ligne de bit $BL_L$ peut être polarisée à 0V et la deuxième ligne de bit $BL_R$ maintenue à VDD. Pour décharger le premier noeud de stockage L à 0V, un courant $I_{MAL-ON}$ qui traverse le premier transistor d'accès $MA_L$ est prévu supérieur au courant $I_{MLR-ON}$ qui traverse le premier transistor de conduction $ML_L$ :

$$I_{MAL-ON} \; > \; I_{MLL-ON}$$

De par la configuration de la cellule 500, dans cet exemple $MA_L$ à une tension de seuil VT basse augmentant $I_{MAL-ON}$ et augmentant la marge en écriture (WM).

En améliorant la marge en écriture, une telle cellule 500 présente un meilleur compromis entre marge en écriture WM et stabilité en lecture SNM qu'une cellule mémoire 6T suivant l'art antérieur, ainsi qu'une meilleure densité d'intégration.

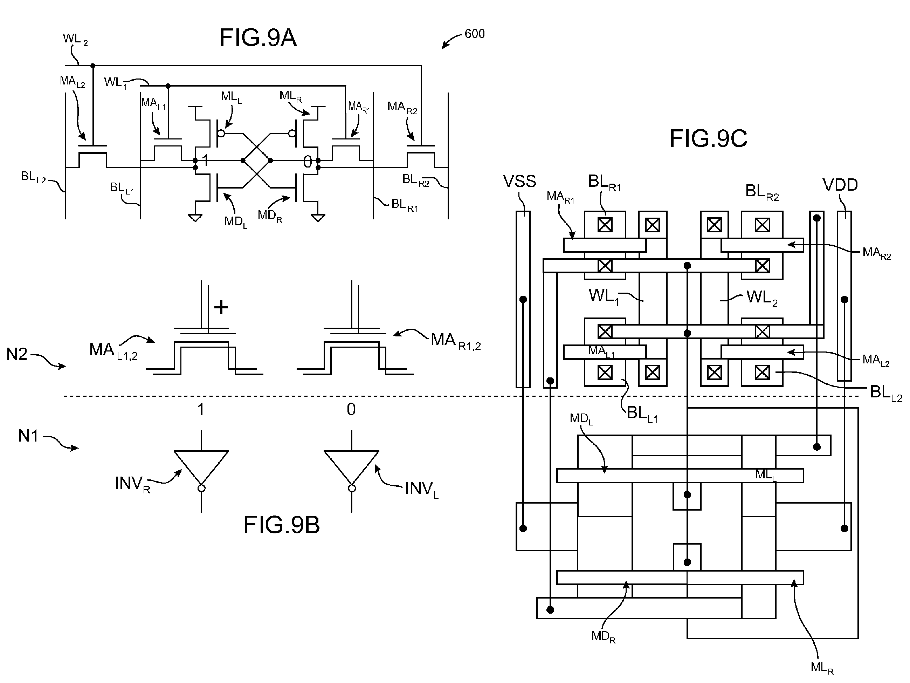

Un sixième exemple de cellule mémoire 600 à accès aléatoire suivant l'invention, est illustré sur les figures 9A-9C.

Cette cellule mémoire 600 est une cellule de mémoire statique SRAM de type double port dotée de 8 transistors. La cellule 600 comprend une pluralité de transistors formant un premier inverseur $INV_L$ et un deuxième inverseur $INV_R$, connectés selon une configuration de bascule. Dans cet exemple, la bascule est formée à l'aide d'un premier transistor de conduction $MD_L$ et d'un deuxième transistor de conduction $MD_R$, par exemple de type NMOS, ainsi que d'un premier transistor de charge $ML_L$ et d'un deuxième transistor de charge $ML_R$, par exemple de type PMOS.

La cellule 600 est également dotée d'un premier transistor d'accès $MA_{L1}$, d'un deuxième transistor d'accès $MA_{L2}$, d'un troisième transistor d'accès $MA_{R1}$, et d'un quatrième transistor d'accès $MA_{R2}$.

Le premier transistor d'accès $MA_{L1}$ est connecté entre une première ligne de bits $BL_{L1}$ et un premier noeud L, tandis que le deuxième transistor d'accès $MA_{L2}$ est connecté entre une deuxième ligne de bits $BL_{L2}$ et ledit premier noeud L.

Le troisième transistor d'accès $MA_{R1}$ est connecté entre une troisième ligne de bits $BL_{R1}$ et un deuxième noeud R, tandis que le quatrième transistor d'accès $MA_{R2}$ est connecté entre une quatrième ligne de bits $BL_{R2}$ et le deuxième noeud R.

Le premier transistor d'accès $MA_{L1}$, et le deuxième transistor d'accès $MA_{L2}$, permettent ainsi d'accéder au premier noeud L de la cellule 600, tandis que le troisième transistor d'accès $MA_{R1}$, et le quatrième transistor d'accès $MA_{R2}$, permettent d'accéder au deuxième noeud R de la cellule 600.

Le premier transistor d'accès $MA_{L1}$ et le troisième transistor d'accès $MA_{R1}$ comportent une grille reliée à une première ligne de mot $WL_1$, tandis que le deuxième transistor d'accès $MA_{L2}$, et le quatrième transistor d'accès $MA_{R2}$, comportent une grille reliée à une deuxième ligne de mot $WL_2$.

Comme cela est illustré sur les figures 9B et 9C, dans la cellule mémoire 600, les transistors $MD_L$, $MD_R$, $MA_L$, $MA_R$, $ML_L$, $ML_R$ sont formés dans un empilement de couches minces et répartis sur 2 niveaux N1, N2 différents de l'empilement, les transistors de conduction $MD_L$ et $MD_R$ et de charge $ML_L$ et $ML_R$ étant situés en dessous des transistors d'accès $MA_{L1}$, $MAL_2$, $MA_{R1}$, $MAR_2$, dans l'empilement.

Les transistors d'accès ont chacun un agencement semblable à celui du deuxième transistor $T_{21}$ de l'exemple de dispositif décrit précédemment en liaison avec les figures 2B-2C, et sont chacun formés au dessus et en regard de la grille d'un des transistors formant les inverseurs INVL et INVR.

L'agencement du premier transistor d'accès $MA_{L1}$, et du deuxième transistor d'accès $MA_{L2}$ par rapport aux transistors du deuxième inverseur $INV_R$ est tel que le premier transistor d'accès $MA_{L1}$, a une zone de canal couplée avec la grille d'un transistor du deuxième inverseur INVR, tandis que le deuxième transistor d'accès $MA_{L2}$, a une zone de canal couplée avec la grille d'un transistor du deuxième inverseur $INV_R$.

L'agencement du troisième transistor d'accès $MA_{R1}$, et quatrième transistors d'accès $MA_{R2}$ par rapport aux transistors du premier inverseur $INV_L$ est tel que le troisième transistor d'accès $MA_{R1}$, a une zone de canal couplée avec la grille d'un transistor du premier inverseur $INV_L$, tandis que le quatrième transistor d'accès $MA_{R2}$, a une zone de canal couplée avec la grille d'un transistor du premier inverseur $INV_L$.

Une telle cellule comporte les inverseurs $INV_R$ et $INV_L$ dans un premier niveau d'un empilement de couches et des transistors d'accès $MA_{L1}$, $MA_{L2}$, $MA_{R1}$, $MA_{R2}$, dans un deuxième niveau dudit empilement.

Un mode de fonctionnement de la cellule 600 est le suivant :

En mode écriture, la ligne de mot WL1 (WL2) est polarisée à VDD pour accéder à la donnée mémorisée dans les noeuds de stockage L, R via respectivement les lignes de bit BLL1, BLR1) et BLR1 (BLR2), tandis que la ligne de mot WL2 (WL1) est polarisée à 0V. Les transistors d'accès $MA_{L1}$ ($MA_{L2}$) et $MA_{R1}$ ($MA_{R2}$) se trouvent alors dans un état conducteur, tandis que les transistors d'accès MAL2 ($MA_{L2}$) et MAR2 ($MA_{R1}$) sont dans un état bloqué. Dans le cas où le premier noeud L est à un niveau logique haut, par exemple au potentiel Vdd, et que le deuxième noeud R est à un niveau logique bas, par exemple à 0 V, le deuxième transistor de conduction $MD_R$ et le premier transistor de charge $ML_L$ sont également conducteurs, tandis que le premier transistor de conduction $MD_L$ et le deuxième transistor de charge $ML_R$ sont bloqués. Dans le cas où on veut écrire un 0, la première ligne de bit $BL_{L1}$ est polarisée à 0V et la troisième ligne de bit $BL_{R1}$ est maintenue à VDD. Pour décharger le premier noeud de stockage L à 0V, un courant $I_{MAL-ON}$ qui traverse le premier transistor d'accès $MA_{L1}$ est prévu supérieur au courant $I_{MLR-ON}$ qui traverse le premier transistor de conduction $ML_L$ :

$$I_{MAL1-ON} > I_{MLL-ON}$$

En raison de la configuration de la cellule 600, dans cet exemple le premier (deuxième) transistor d'accès $MA_{L1}$ ($MAL_2$) à un VT bas augmentant $I_{MAL-ON}$ et augmentant la marge en écriture (WM).

En améliorant la marge en écriture, une telle cellule 600 présente un meilleur compromis entre marge en écriture WM et stabilité en lecture SNM qu'une cellule mémoire double port à 8 transistors suivant l'art antérieur, ainsi qu'une meilleure densité d'intégration.

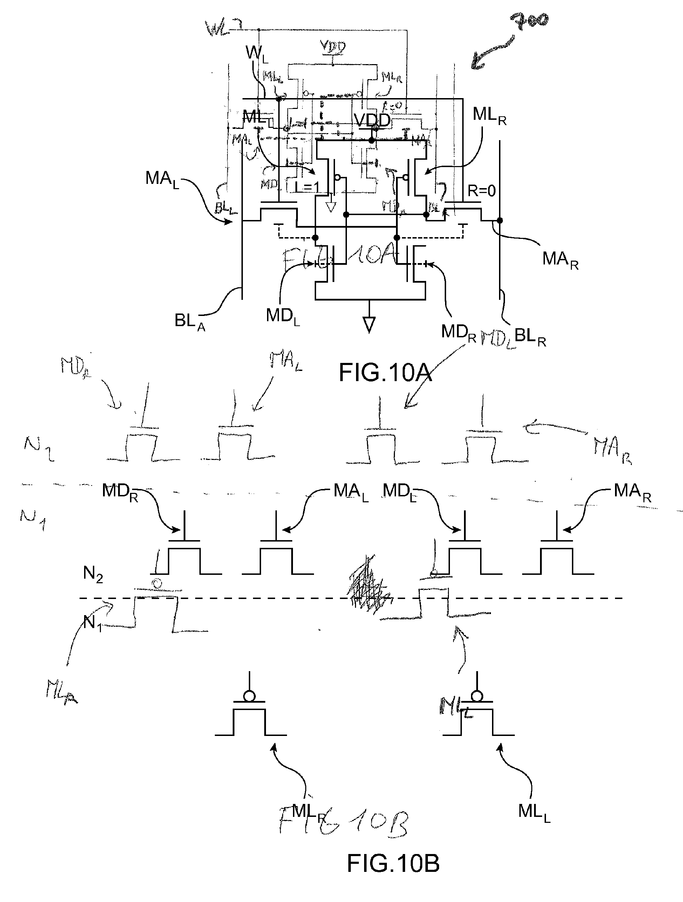

Un septième exemple de cellule mémoire 700 à accès aléatoire suivant l'invention, est illustré sur les figures 10A-10B.

La cellule mémoire 700 est également une cellule de mémoire statique SRAM de type 6T.

Dans la cellule mémoire 700, les transistors de charge $ML_L$, $ML_R$ sont formés dans le premier niveau N1 d'un empilement de couches, tandis que les transistors de conduction $MD_L$, $MD_R$, sont formés dans un deuxième niveau N2 de l'empilement situé au dessus du premier niveau N1, les transistors d'accès $MA_L$, $MA_R$, étant également formés dans le deuxième niveau N2.

L'agencement des transistors d'accès $MA_L$, $MA_R$ par rapport aux transistors de charge $ML_L$, $ML_R$ est tel que la tension de seuil du premier transistor d'accès $MA_L$, dépend de la polarisation de la grille du deuxième transistor de charge $ML_R$, tandis que la tension de seuil du deuxième transistor d'accès $MA_R$, dépend de la polarisation de la grille du premier transistor de conduction charge $ML_L$.

Un couplage, d'une part entre la grille du premier transistor de charge $ML_L$ et le canal du deuxième transistor d'accès $MA_R$, et d'autre part entre la grille du premier transistor de charge $ML_L$ et le canal du premier transistor de conduction $MD_L$, est illustré par l'intermédiaire de traits discontinus sur la figure 10A.

Un couplage, d'une part entre la grille du deuxième transistor de charge $ML_R$ et le canal du premier transistor du premier transistor d'accès $MA_L$, et d'autre part entre la grille du deuxième transistor de charge $ML_R$ et le canal du deuxième transistor de conduction $MD_R$, est également illustré par l'intermédiaire de traits discontinus.

L'agencement des transistors de conduction $MD_L$, $MD_R$ par rapport aux transistors de charge $ML_L$, $ML_R$, est tel que la tension de seuil du premier transistor de conduction $MD_L$, dépend de la polarisation de la grille du premier transistor de charge $ML_L$, tandis que la tension de seuil du deuxième transistor de conduction $MD_R$, dépend de la polarisation de la grille du deuxième transistor de charge $ML_R$.

Dans cette architecture, le maintien du noeud R à un niveau logique bas est renforcé grâce à la grille arrière des transistors $MA_R$ et $MD_L$ transistors, c'est-à-dire à la manière dont est polarisée la grille du transistor de charge $ML_L$, couplé aux canaux des transistors $MA_R$ et $MD_L$.

**Revendications**

1.   Cellule de mémoire vive statique à accès aléatoire, comprenant sur un substrat surmonté d'un empilement de couches :

- une première pluralité de transistors situés à un niveau donné de l'empilement dont au moins un premier transistor d'accès ($MA_L$) et au moins un deuxième transistor d'accès ($MA_R$) connectés à une ligne de mot (WL, WL1) et disposés respectivement entre une première ligne de bit ($BL_L$) et un premier noeud de stockage (L), et entre une deuxième ligne de bit ($BL_R$) et un deuxième noeud de stockage (R),
- une deuxième pluralité de transistors ($ML_L$, $ML_R$, $MD_L$, $MD_R$) formant une bascule et situés à au moins un autre niveau de l'empilement en dessous dudit niveau donné,

les transistors de la deuxième pluralité de transistors ($ML_L$, $ML_R$, $MD_L$, $MD_R$) comportant chacun une électrode de grille située en regard d'une zone de canal d'un transistor de la première pluralité de transistors ($MA_L$, $MA_R$) et séparée de cette zone de canal par l'intermédiaire d'une zone isolante prévue pour permettre un couplage entre ladite électrode de grille et ladite zone de canal.

2. Cellule de mémoire vive Cellule de mémoire vive statique à accès aléatoire selon la revendication 1, dans lequel la deuxième pluralité de transistors est formée :

d'un premier transistor de conduction ($MD_L$) et d'un deuxième transistor de conduction ($MD_R$), le premier transistor de conduction ($MD_L$) ayant une grille située en regard de, et couplé à, la zone de canal du premier transistor d'accès ($MA_L$), le deuxième transistor de conduction ($MD_R$) ayant une grille située en regard de, et couplé à, la zone de canal du deuxième transistor d'accès ($MA_R$).

3. Cellule de mémoire Cellule de mémoire vive statique à accès aléatoire selon la revendication 1, dans lequel la deuxième pluralité de transistor est formée : d'un premier transistor de charge ($ML_L$) et d'un deuxième transistor de charge ($ML_R$), le premier transistor de charge ($ML_L$) ayant une grille située en regard de, et couplé à, la zone de canal du premier transistor d'accès ($MA_L$), le deuxième transistor de charge ($ML_R$) ayant une grille située en regard de, et couplé à, la zone de canal du deuxième transistor d'accès ($MA_R$).

4. Cellule de mémoire vive statique à accès aléatoire, selon la revendication 1, dans lequel la deuxième pluralité de transistor est formée : d'un premier transistor de charge ($ML_L$) et d'un deuxième transistor de charge ($ML_R$), d'un premier transistor de conduction ($MD_L$), et d'un deuxième transistor de conduction ($MD_R$).

5. Cellule de mémoire vive statique à accès aléatoire selon la revendication 4, le premier transistor de charge ($ML_L$) et le deuxième transistor de charge ($ML_R$) étant respectivement, disposés en regard et couplés, au deuxième transistor de conduction ($MD_L$) et au premier transistor de conduction ($MD_L$).

6. Cellule de mémoire vive statique à accès aléatoire selon la revendication 4, le premier transistor de charge ($ML_L$), le deuxième transistor de charge ($ML_R$), le premier transistor de conduction ($MD_L$), et le deuxième transistor de conduction ($MD_L$) étant formés dans un même niveau dudit empilement.

7. Cellule de mémoire vive statique à accès aléatoire selon la revendication 1, dans lequel la première pluralité de transistors comprend en outre : au moins un troisième transistor d'accès ($MA_{L2}$) et au moins un quatrième transistor d'accès ($MA_{R2}$), disposés respectivement entre une troisième ligne de bit ($BL_L$) et le premier noeud de stockage (L), et entre une quatrième ligne de bit ($BL_R$) et un deuxième noeud de stockage (R), le troisième transistor d'accès et le quatrième transistor d'accès ayant une grille connectés à une deuxième ligne de mot ($WL_2$).

8. Cellule de mémoire vive statique à accès aléatoire selon l'une des revendications 1 à 7, dans lequel ladite zone isolante (120) a une épaisseur équivalente en $SiO_2$ comprise entre 1 et 50 nanomètres.

9. Cellule de mémoire vive statique à accès aléatoire selon l'une des revendications 1 à 8, le couplage étant tel qu'une variation du potentiel de ladite électrode de grille entraine une variation de la tension de seuil de ladite zone de canal.

10. Cellule de mémoire vive statique à accès aléatoire selon l'une des revendications 1 à 9, la cellule ayant une tension d'alimentation Vdd, le couplage étant tel qu'une variation du potentiel de ladite électrode de grille d'au plus de Vdd, permette d'obtenir une variation de la tension de seuil de ladite zone de canal d'au moins 50 mV.

11. Cellule de mémoire vive statique à accès aléatoire selon l'une des revendications 1 à 10, dans lequel entre ladite grille et ladite zone de canal, ladite zone isolante (120) est formée d'une première région (R1, R'1) à base d'un premier matériau diélectrique (420) ayant une première constante diélectrique $k_1$, en regard des zones de source et de drain, ladite zone isolante étant formée d'une deuxième région (R2, R'2) comportant au moins un deuxième matériau diélectrique (422) ayant une deuxième constante diélectrique $k_2$ telle que $k_2 < k_1$.

12. Cellule de mémoire vive statique à accès aléatoire selon la revendication 11, ladite deuxième région (R'2) comportant un empilement dudit premier matériau diélectrique (420) et dudit deuxième matériau diélectrique (422).

FIG.1

FIG.2A

FIG.2B

FIG.2C

FIG.3A

FIG.3B

FIG.4

FIG.3C

## FIG.5A

## FIG.5B

## FIG.5C

EP 2 131 396 A1

FIG.6A

FIG.6C

FIG.6B

EP 2 131 396 A1

FIG.7A

WL

400

$ML_L$   $ML_R$

$MA_L$   $MA_R$

$BL_L$   $BL_R$

$MD_L$   $MD_R$

FIG.7C

+

$MA_L$   $MA_R$

1   0

+

$MD_R$   $MD_L$

1   0

$ML_R$   $ML_L$

FIG.7B

VSS   WL   WL   VSS

VDD   $MA_R$

$BL_R$

$MA_L$   VDD

$BL_L$

$MD_R$   $MD_L$

$ML_R$   $ML_L$

EP 2 131 396 A1

FIG.8C

FIG.8A

FIG.8B

FIG.9A

600

FIG.9B

N2  MA$_{R1,2}$  MA$_{L1,2}$  INV$_L$  INV$_R$  N1

FIG.9C

FIG.10A

FIG.10B

Europäisches
Patentamt

European
Patent Office

Office européen
des brevets

**RAPPORT DE RECHERCHE EUROPEENNE**

Numéro de la demande

EP 09 16 0432

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2005/184292 A1 (KWAK KUN-HO [KR] ET AL) 25 août 2005 (2005-08-25) * alinéas [0074] - [0083]; figures 1,12 * | 1-6,8-10 | INV. H01L27/11 H01L21/8244 |
| Y | | 7 | |
| | ----- | | |
| X | US 2005/221544 A1 (KWAK KUN-HO [KR] ET AL) 6 octobre 2005 (2005-10-06) * alinéas [0078] - [0088]; figures 1,14 * | 1-6,8-10 | |
| | ----- | | |
| Y | EP 0 920 025 A (ST MICROELECTRONICS SRL [IT]) 2 juin 1999 (1999-06-02) * alinéas [0057] - [0065]; figure 8 * | 7 | |
| | ----- | | |

| | DOMAINES TECHNIQUES RECHERCHES (IPC) |
|---|---|
| | H01L |

Le présent rapport a été établi pour toutes les revendications

| Lieu de la recherche | Date d'achèvement de la recherche | Examinateur |
|---|---|---|
| La Haye | 19 août 2009 | Franche, Vincent |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 09 16 0432

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-08-2009

| Document brevet cité au rapport de recherche | | Date de publication | Membre(s) de la famille de brevet(s) | | Date de publication |
|---|---|---|---|---|---|
| US 2005184292 | A1 | 25-08-2005 | US | 2007241335 A1 | 18-10-2007 |
| US 2005221544 | A1 | 06-10-2005 | AUCUN | | |
| EP 0920025 | A | 02-06-1999 | DE | 69727581 D1 | 18-03-2004 |
| | | | JP | 11232878 A | 27-08-1999 |
| | | | US | 2002003244 A1 | 10-01-2002 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Lim ; Fossum.** *IEEE Transactions on electron devices,* Octobre 1983, vol. ED-30 (10